# EUROPEAN PATENT APPLICATION

(11) **EP 2 641 688 A1**
(43) Date of publication of application: **25.09.2013**
(21) Application number: 13001285.9
(22) Date of filing: 14.03.2013
(51) Int. Cl.: B23K 26/06, B23K 26/073, G02B 27/09

(54) **Laser processing apparatus and laser processing method**

(30) Priority: 21.03.2012 JP 2012063134
(71) Applicant: SUMITOMO HEAVY INDUSTRIES, LTD., Tokyo 141-6025 (JP)
(72) Inventor: Shudo, Kazumasa, Kanagawa, 237-8555 (JP)
(74) Representative: Wagner, Karl H.

(57) **Abstract**

A laser processing apparatus capable of decreasing influence of processing qualitydue to the change of a work distance is provided. A laser beam which is emitted from a laser light source is incident to an optical homogenizer (22). The optical homogenizer(22) makes the laser beam be incident to a region having an elongated shape in a first direction (x) on a workpiece (30). An inclination optical device (25) is disposed on a pathway of the laser beam between the optical homogenizer (22) and the workpiece (30). The inclination optical device (25) forms a refractive index interface inclined in a direction perpendicular to the first direction with respect to a surface of the workpiece (30).

## Description

### FIELD OF THE INVENTION

The present invention relates to a laser processing apparatus and a laser processing method which perform processing of a workpiece using a laser beam having an elongated cross-section incident upon the workpiece while moving the workpiece in a direction crossing a longitudinal direction of the elongated cross-section of the laser beam.

The present application claims priority based on Japanese Patent Application No. 2012-063134, filed March 21, 2012, the entire contents of which are incorporated herein by reference.

### BACKGROUND OF THE INVENTION

A laser processing apparatus which performs laser annealing by lengthening a beam cross-section of a laser beam is disclosed in Patent Document 1. In the laser processing apparatus, a light intensity distribution is homogenized with respect to both directions of a long axis direction and a short axis direction of the beam cross-section. In Patent Document 2, a technology is disclosed which disposes a workpiece in a position defocused from a focus position of an optical homogenizer and performs laser annealing. By performing the defocusing, a light intensity distribution in which a monotonous increase and a monotonous decrease are periodically repeated is obtained. Crystal grains can be enlarged by performing crystallization annealing to an amorphous film using the laser beam having the light intensity distribution.

### [Prior Art Document]

[Patent Document 1] Japanese Unexamined Patent Publication No. 2006-195325
[Patent Document 2] Japanese Unexamined Patent Publication No. 2010-263240

### SUMMARY OF THE INVENTION

In order to form a high quality polycrystalline film, it is preferable to make an inclination of both ends of the light intensity distribution with respect to the short axis direction be gentle. Generally, if the light intensity distribution is homogenized by the optical homogenizer, the inclination of both ends of the light intensity distribution becomes steep. If a workpiece is disposed on a position defocused from the focus position of the optical homogenizer, the inclination of both ends of the light intensity distribution becomes gentle. However, if a distance (work distance) from the optical homogenizer to the workpiece is changed, the inclination of both ends of the light intensity distribution is changed significantly. Thereby, if there is an undulation or the like on the surface of the workpiece, processing quality fluctuates on the surface.

An object of the present invention is to provide a laser processing apparatus and a laser processing method capable of decreasing influence of the change of a work distance on processing quality.

According to an aspect of the present invention, there is provided a laser processing apparatus including: a laser light source; an optical homogenizer which makes a laser beam emitted from the laser light source be incident to a region having an elongated shape in a first direction on a workpiece; and an inclination optical device which is disposed on a pathway of the laser beam between the optical homogenizer and the workpiece and forms a refractive index interface inclined in a direction perpendicular to the first direction with respect to a surface of the workpiece.

According to another aspect of the present invention, there is provided a laser processing method in which a workpiece is processed using a laser processing apparatus, the apparatus including a laser light source which emits a pulse laser beam; an optical homogenizer which make the laser beam emitted from the laser light source be incident upon a region having an elongated shape in a first direction on the workpiece; and an inclination optical device which is disposed on an optical path of the laser beam between the optical homogenizer and the workpiece and forms a refractive index interface inclined in a direction perpendicular to the first direction with respect to a surface of the workpiece, the method includes: a first processing step of performing the processing by emitting the pulse laser beam from the laser light source while moving the workpiece in a second direction perpendicular to the first direction; a step of shifting the workpiece in the first direction after the first processing step; a second processing step of performing the processing by emitting the pulse laser beam from the laser light source while moving the workpiece in a direction opposite to the movement direction of the workpiece in the first processing step, after shifting the workpiece in the first direction; and a step of inverting the inclination direction of the refractive index interface between the first processing step and the second processing step.

Since the inclination optical device is disposed, the inclinations of both ends of the light intensity distribution with respect to the direction perpendicular to the first direction can be gentle even in a just focus state. If the laser processing is performed in the just focus state, the change in processing quality due to change of a work distance becomes small.

### BRIEF DESCRIPTION OF THE DRAWINGS

Figs. 1A and 1B are schematic views of a long axis plane and a short axis plane of a laser processing apparatus according to Embodiment 1 respectively.
Fig. 2 is a view showing a disposition of an optical device which affects behavior of a laser beam with respect to the short axis plane of the laser processing apparatus according to Embodiment 1.
Figs. 3A and 3B are graphs showing a light intensity distribution of a short axis direction on the surface of a workpiece.
Fig. 4 is a graph showing a relationship between a change in pulse energy and lightness of a film after crystallization.
Figs. 5A and 5B are graphs showing the light intensity distribution in a just focus state and a defocus state respectively.
Fig. 6 is a graph showing a relationship between a position in a Z direction of the workpiece and inclinations of the light intensity distribution at both ends.
Fig. 7 is a cross-sectional view of a mounting portion of a condenser lens and an inclination optical device of a laser processing apparatus according to Embodiment 2.
Figs. 8A and 8B are cross-sectional views showing a posture of the inclination optical device when a laser radiation is performed while the workpiece moves in a positive direction and a negative direction of a y axis respectively.
Fig. 9 is a view showing a disposition of the optical device which affects behavior of a laser beam with respect to the short axis plane of a laser processing apparatus according to Embodiment 3.
Figs. 10A to 10C are graphs showing the light intensity distribution on the surface of the workpiece when the laser processing apparatus is used according to Embodiment 3.
Fig. 11 is a perspective view of the inclination optical device and a support frame of the laser processing apparatus according to Embodiment 3.

### DESCRIPTION OF THE EMBODIMENTS

### [Embodiment 1]

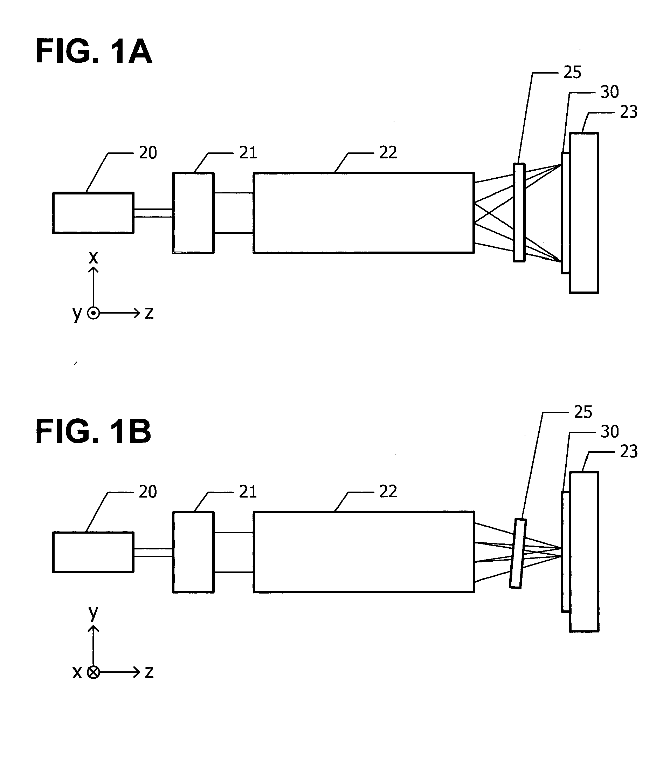

Figs. 1A and 1B are schematic views showing a laser processing apparatus according to Embodiment 1. The laser processing apparatus according to Embodiment 1 forms an elongated beam cross-section which is long in one direction on the surface of a workpiece. An xyz rectangular coordinate system is defined in which a long axis direction of the beam cross-section corresponds to an x direction, a short axis direction corresponds to a y direction, and a propagation direction of the laser beam corresponds to a z direction. Fig. 1A shows behavior of the laser beam in a zx plane (long axis plane), and Fig. 1B shows behavior of the laser beam in a yz plane (short axis plane).

A laser light source 20 emits a pulse laser beam. A beam expander 21 enlarges a beam diameter of the laser beam which is emitted from the laser light source 20. The laser beam in which the beam diameter has been enlarged is incident to an optical homogenizer 22. The workpiece 30 is held to a stage 23. The stage 23 can move the workpiece 30 in the x direction and the y direction. Figs. 1A and 1B shows the example in which a pathway of the laser beam is along a straight line without bending. Instead, a bendingmirror is disposed if necessary, and the pathway of the laser beam may be bent. For example, when the stage 23 is fixed in a posture in which the holding surface for the workpiece 30 faces upward, the pathway of the laser beam which is emitted in a horizontal direction from the laser light source 20 may be bent downward.

The optical homogenizer 22 makes the beam cross-section of the laser beam have an elongated shape that is long in the x direction on the surface of the workpiece 30. Moreover, the optical homogenizer 22 homogenizes the light density on the surface of the workpiece 30 with respect to the x direction and the y direction.

An inclination optical device 25 is disposed on the pathway of the laser beam between the optical homogenizer 22 and the workpiece 30. For example, a parallel flat plate through which the laser beam is transmitted is used for the inclination optical device 25. The inclination optical device 25 is inclined in a short axis direction (y direction) with respect to the surface of the workpiece 30. Thereby, a refractive index interface which is inclined in the short axis direction (y direction) with respect to the surface of the workpiece 30 is formed.

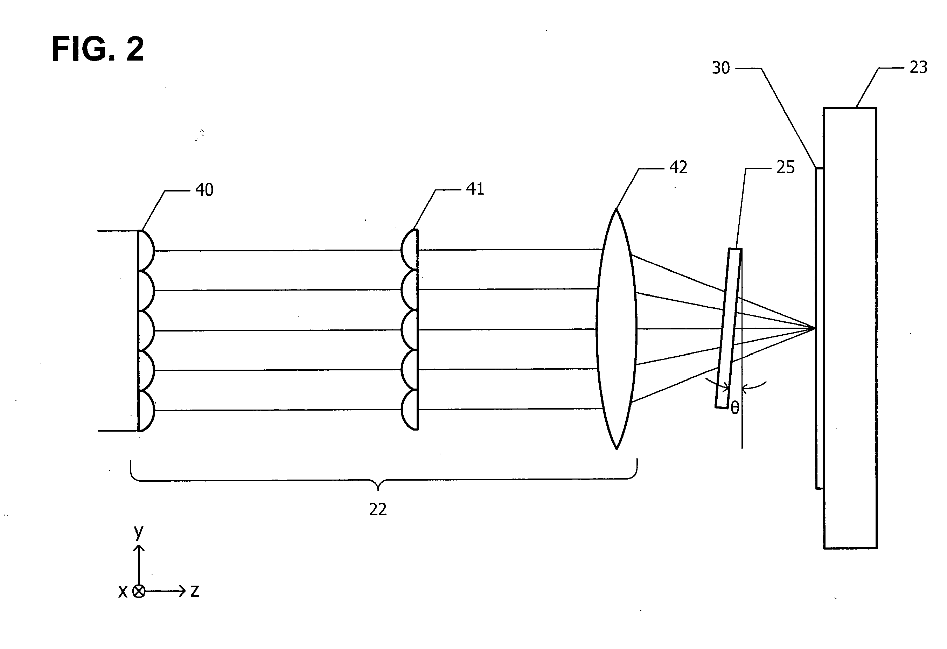

Fig. 2 shows the disposition of the optical devices related to the behavior of the laser beam with respect to the yz plane. The optical devices include a first cylindrical lens array 40, a second cylindrical lens array 41, and a condenser lens 42 on the pathway of the laser beam in the recited order from the light source side. Each of the first cylindrical lens array 40 and the second cylindrical lens array 41 includes a plurality of convex cylindrical lenses. The convex cylindrical lenses have power in the y direction and are arranged in the y direction. The convex cylindrical lenses of the first cylindrical lens array 40 and the convex cylindrical lenses of the second cylindrical lens array 41 correspond to each other in one to one. Fig. 2 shows an example in which each of the first cylindrical lens array 40 and the second cylindrical lens array 41 includes five convex cylindrical lenses.

The first cylindrical lens array 40 divides the laser beam incident to the optical homogenizer 22 into a plurality of (five in Fig. 2) laser beams with respect to the short axis direction (y direction). Each of the laser beams, which becomes converged pencil of rays with respect to the yz plane due to each of the convex cylindrical lenses of the first cylindrical lens array 40, is incident upon corresponding convex cylindrical lens of the second cylindrical lens array 41. Fig. 2 shows only a central ray of each of the divided laser beams.

The laser beams which transmit the second cylindrical lens array 41 are incident upon the condenser lens 42. The condenser lens 42 has power in the short axis direction (y direction), and condenses the incident laser beams on the surface of the workpiece 30 with respect to the yz plane. The optical axis of the condenser lens 42 and the surface of the workpiece 30 are perpendicular to each other with respect to the yz plane. That is, the central laser beam of the laser beams divided due to the first cylindrical lens array is perpendicularly incident upon the workpiece 30.

Each of the convex cylindrical lenses of the first cylindrical lens array 40 is disposed at the front side focus position of the corresponding convex cylindrical lenses of the second cylindrical lens array 41. The surface of the workpiece 30 is disposed at the rear side focus position of the condenser lens 42. Thereby, the second cylindrical lens array 41 and the condenser lens 42 provide an image of the beam cross-sectional shape of the position of the first cylindrical lens array 40 on the surface of the workpiece 30. That is, an imaging optical system is configured in which the position, at which the first cylindrical lens array 40 is allocated, corresponds to an object point and the surface of the workpiece 30 corresponds to an image point.

The inclination optical device 25 is disposed between the condenser lens 42 and the workpiece 30. The inclination optical device 25 is inclined in the short axis direction (y direction) with respect to the surface of the workpiece 30. The inclination angle of the inclination optical device 25 is represented by θ. Since the inclination optical device 25 is a parallel flat plate, the inclination optical device 25 does not affect the imaging conditions.

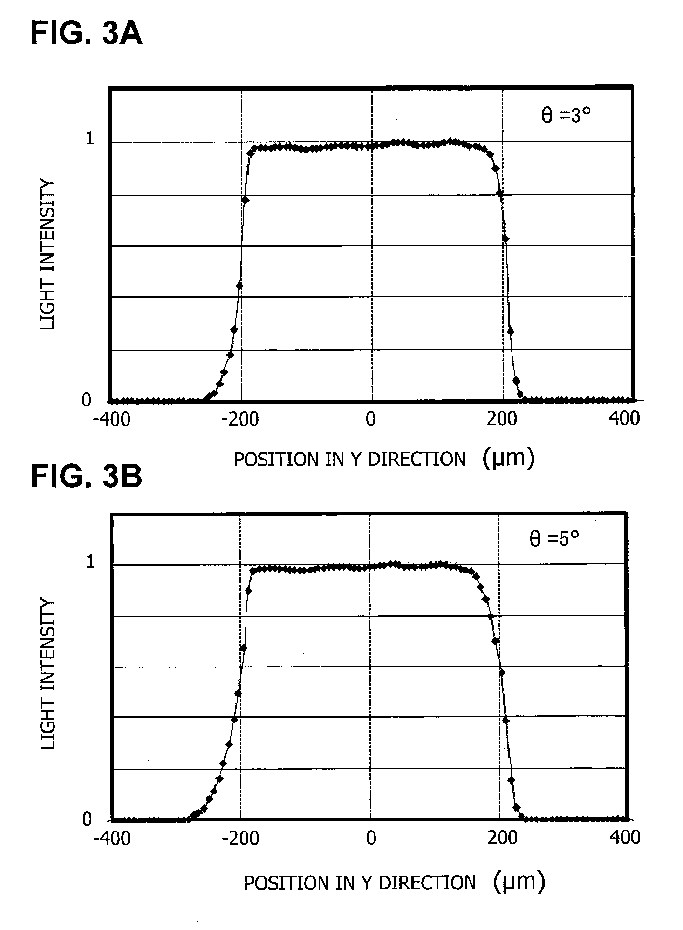

Figs. 3A and 3B show simulation results of the light intensity distribution in the short axis direction (y direction) on the surface of the workpiece 30. The horizontal axis represents the positions in the y direction based on a position of the focal point of the condenser lens 42 (Fig. 2) by a unit "µm". The vertical axis represents the light intensity as a relative value to the maximum value when the maximum value is represented as "1". Fig. 3A shows a case where the inclination angle θ is 3°, and Fig. 3B shows a case where the inclination angle θ is 5°.

In both cases of Fig. 3A and Fig. 3B, the light intensity distribution having a substantially top flat shape is obtained. If the inclination angle θ is increased from 3° to 5°, the inclinations of both ends of the light intensity distribution become gentle. In this way, if the inclination angle θ is increased, the inclinations of both ends of the light intensity distribution can be gentle.

The shape of the light intensitydistributionis bilaterally asymmetric with respect to the center. When polycrystallization annealing is performed to an amorphous silicon film which is formed on the surface of the workpiece 30, irradiation of the pulse laser beam is performed while moving the workpiece 30 in the short axis direction (y direction) of the beam cross-section. The movement speed of the workpiece 30 is set so that the irradiation area of the last shot and the irradiation area of the new shot are partially overlapped.

In Embodiment 1, since the inclinations of the light intensity distribution at both ends can be gentle, processing quality can be enhanced. A preferable range of the inclination angle θ of the inclination optical device 25 can be determined by performing a plurality of evaluation tests with various inclination angles θ.

In Embodiment 1, since the light intensity distribution in the short axis direction is bilaterally asymmetric, it is considered that the movement direction of the workpiece 30 affects the processing quality. Accordingly, in order to decrease fluctuation of the processing quality on the surface, it is preferable that the movement direction of the workpiece 30 be fixed to any one of the positive directions and the negative directions of the y axis. It may be determined which direction of the movement direction is to be fixed by actually performing the evaluation tests.

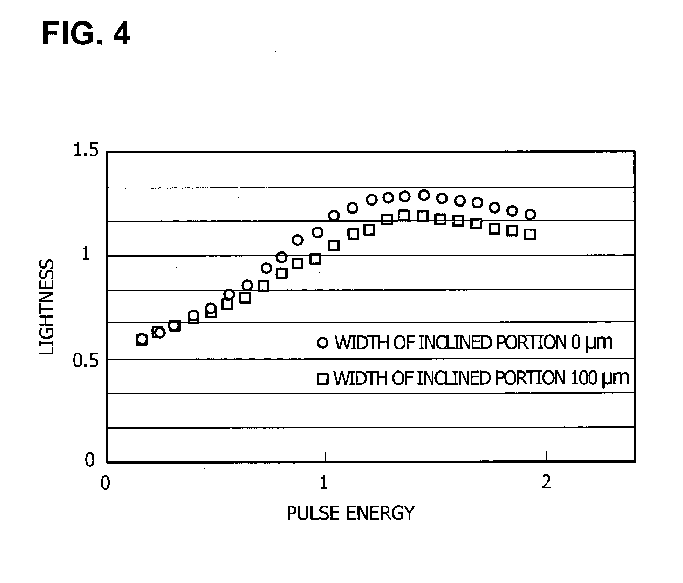

Fig. 4 shows measurement results of lightness of the crystallization film when the crystallization annealing is performed with various inclinations of the light intensity distribution at both ends. In the evaluation tests, the laser pulse of a single shot is radiated to the amorphous silicon film, and the lightness of the crystallized region was measured. The horizontal axis represents the pulse energy of the laser pulse incident upon the amorphous silicon film as a relative value, and the vertical axis represents the lightness of the crystalline silicon film after the irradiation as a relative value. Transparency increases downward in the vertical axis. Square marks and circle marks of Fig. 4 show results when annealing is performed while the widths of the inclined portions of the light intensity distribution at both ends are 100 µm and 0 µm respectively. Here, the "widths of the inclined portions" are defined by the width from the position of 10% of the peak power to the position of 90% of the peak power.

If the inclination optical device 25 (Fig. 2) is inclined, change in lightness decreases with respect to change in pulse energy. The pulse energy on the surface of the workpiece 30 is changed due to change in pulse energy change of laser oscillator itself and due to change in transmission efficiency caused by the pointing stability. If the inclination optical device 25 is inclined, even though the pulse energy is changed, the fluctuation of the lightness in the surface can be suppressed.

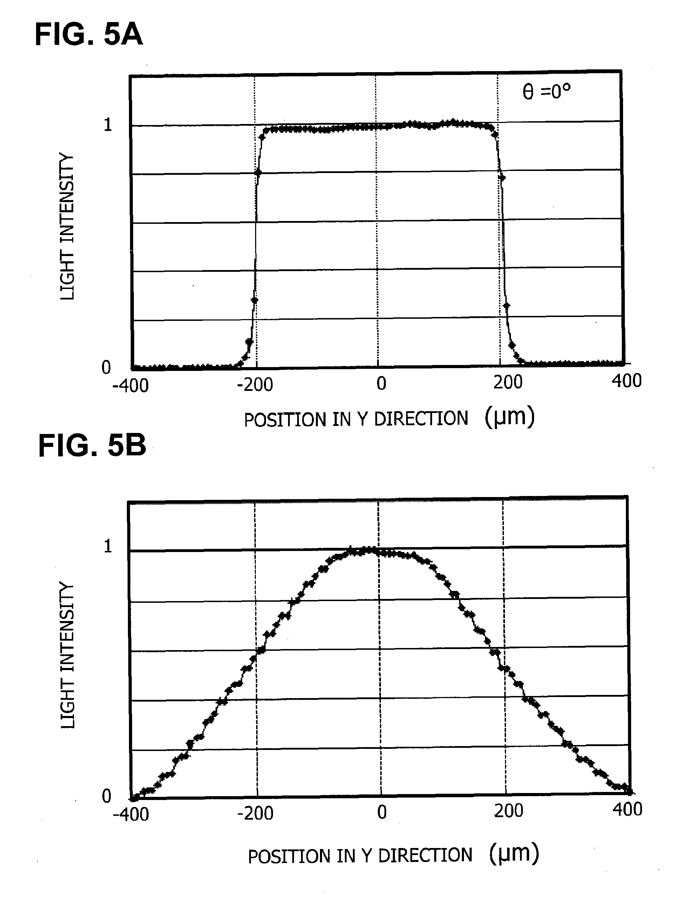

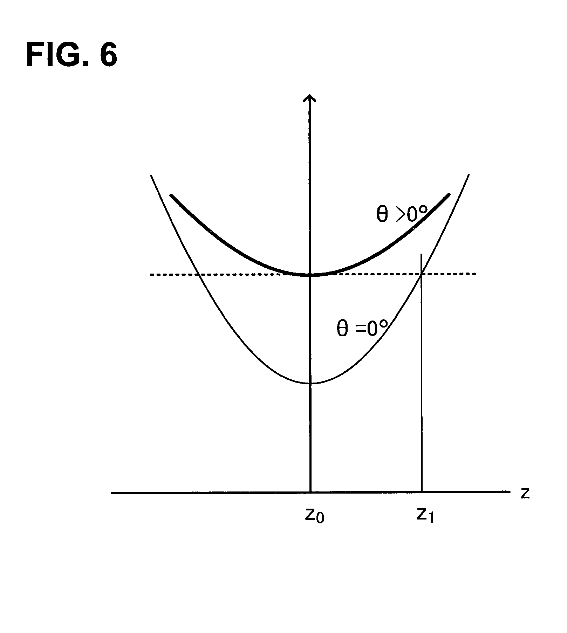

Next, advantageous effects obtained by using the laser processing apparatus according to Embodiment 1 will be described with reference to Figs. 5A, 5B, and 6.

Fig. 5A shows the light intensity distribution in the short axis direction when the inclination angle θ of the inclination optical device 25 (Fig. 2) is 0°. Fig. 5B shows the light intensity distribution under the defocus condition. In Fig. 2, the defocus condition can be obtained by shifting the workpiece 30 in the z direction. In the defocus condition, the inclinations of the light intensity distribution at both ends become gentle. That is, the effects similar to the state where the inclination optical device 25 (Fig. 2) is inserted are obtained.

Fig. 6 shows a relationship between the positions in the z direction of the workpiece 30 and the inclinations of the light intensity distribution at both ends in the short axis direction. The horizontal axis represents the positions in the z direction, and the vertical axis represents the inclinations of the light intensity distribution at both ends. The thin solid line of Fig. 6 shows the inclinations of the light intensity distribution at both ends when the inclination angle θ of the inclination optical device 25 is 0°, and the thick solid line shows the inclinations of the light intensity distribution at both ends when the inclination optical device 25 is inclined.

When the position of the workpiece 30 is z₀, a just focus condition is obtained. If the inclination optical device 25 is inclined under the just focus condition, compared to the case where the inclination angle θ is 0°, the inclinations of the light intensity distribution at both ends are increased. If the position of the workpiece 30 is shifted up to z₁ and a defocus condition is obtained, even when the inclination angle θ is 0°, similar to the case where the inclination optical device 25 is inclined, the inclinations of the light intensity distribution at both ends can be gentle.

Under the just focus condition, the change in inclinations of the light intensity distribution at both ends is decreased with respect to the change of the position in the z direction of the workpiece 30. However, under the defocus condition, the change in inclinations of the light intensity distribution at both ends is increased with respect to the change in position in the z direction of the workpiece 30. Thereby, if the laser radiation is performed under the defocus condition, the laser processing is easily subjected to influence of undulation of the surface of the workpiece 30. Like Embodiment 1, by performing laser radiation under the just focus condition, the laser processing cannot be easily subjected to the influence of the undulation of the surface of the workpiece 30.

### [Embodiment 2]

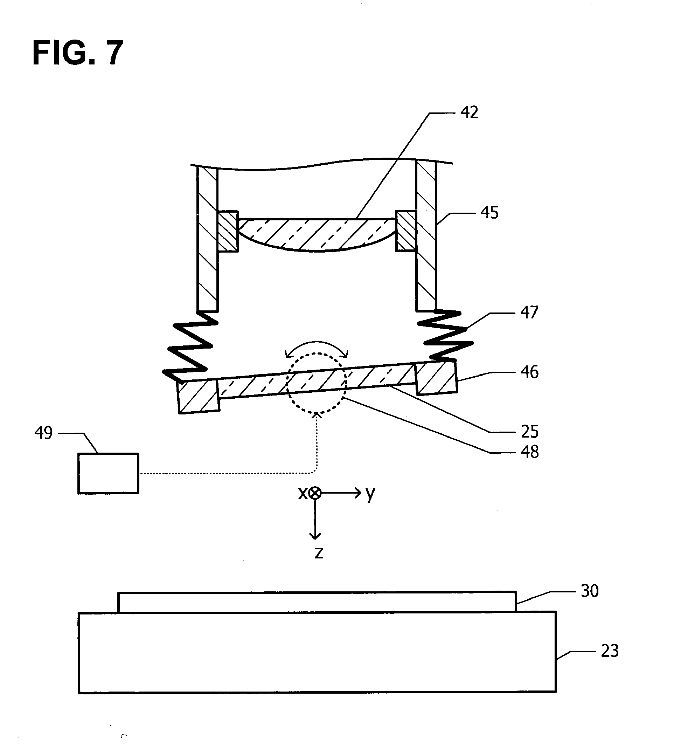

Fig. 7 shows a cross-sectional view of a mounting portion of the condenser lens 42 and the inclination optical device 25 of the laser processing apparatus according to Embodiment 2. The condenser lens 42 is supported to the inside of a lens barrel 45. The inclination optical device 25 is supported to a support frame 46. The support frame 46 is connected to the lens barrel 45 via a bellows 47. The bellows 47 allows the change in posture of the support frame 46 with respect to the lens barrel 45.

The support frame 46 is supported by a rotational shaft 48 which is parallel in the x direction. A rotation-driving mechanism 49 rotates the rotational shaft 48 within a predetermined angle range. The rotational shaft 48 is rotated, and thus, the inclination direction of the inclination optical device 25 with respect to the workpiece 30 can be inverted.

The inclination optical device 25 also includes a function as a protection window which prevents scattered substances from being attached to the condenser lens 42 from the incident position of the laser beam. The bellows 47 prevents the scattered substances from going around the inclination optical device 25, passing across the lateral side of the pathway of the laser beam and being attached to the condenser lens 42.

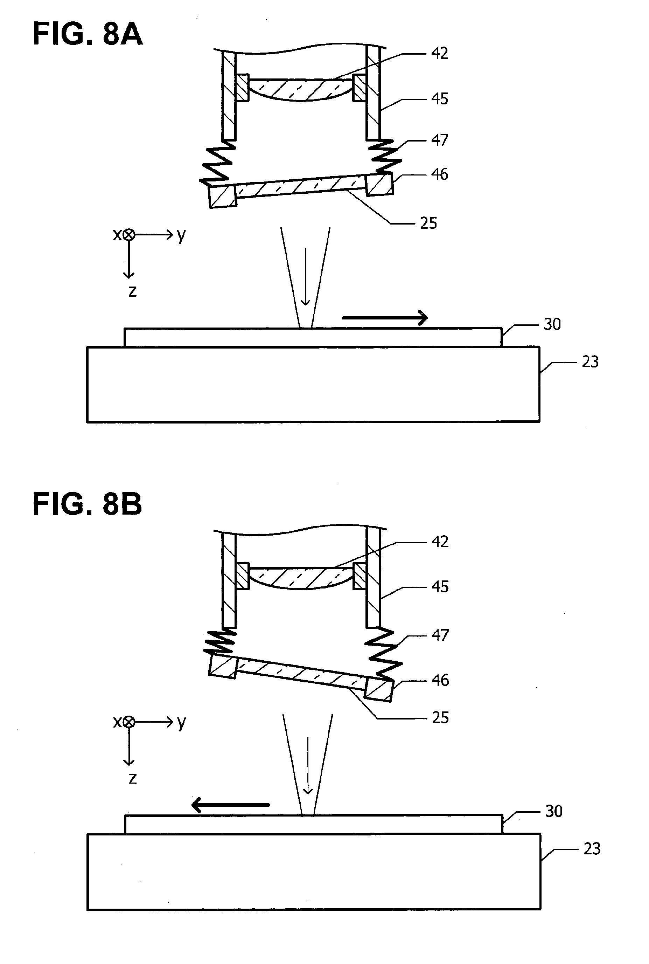

Figs. 8A and 8B show the posture of the inclination optical device 25 when the laser radiation is performed while moving the workpiece 30 in the positive direction and the negative direction of the y axis respectively. The inclination direction of the inclination optical device 25 when the workpiece 30 moves in the negative direction of the y axis is reversed with the inclination direction of the inclination optical device 25 when the workpiece 30 moves in the positive direction of the y axis. Thereby, even though the shape of the light intensity distribution is bilaterally asymmetric as shown in Figs. 3A and 3B, the annealing can be performed under the same condition when the movement direction of the workpiece 30 is inverted.

Next, a specific procedure when the laser processing is performed will be described. First, as shown in Fig. 8A, the processing is performed by emitting the pulse laser beam from the laser light source 20 (Figs. 1A and 1B) while moving the workpiece 30 in the positive direction of the y axis. Thereafter, the workpiece 30 is shifted in the x direction. After the workpiece 30 is shifted in the x direction, as shown in Fig. 8B, the processing is performed by emitting the pulse laser beam from the laser light source 20 while moving the workpiece 30 in the negative direction of the y axis.

The inclination direction of the inclination optical device 25 is inverted by operating the rotation-driving mechanism 49 (Fig. 7) between the process in which the laser radiation is performed while moving the workpiece 30 in the positive direction of the y axis and the process in which the laser radiation is performed while moving the workpiece 30 in the negative direction of the y axis.

In the laser processing apparatus according to Embodiment 2, even though the movement direction of the workpiece 30 is inverted, the laser processing can be performed at the same condition as that before the inversion. Since the laser processing can be performed at both a forward path and a backward path of the workpiece 30, laser processing time can be shortened.

### [Embodiment 3]

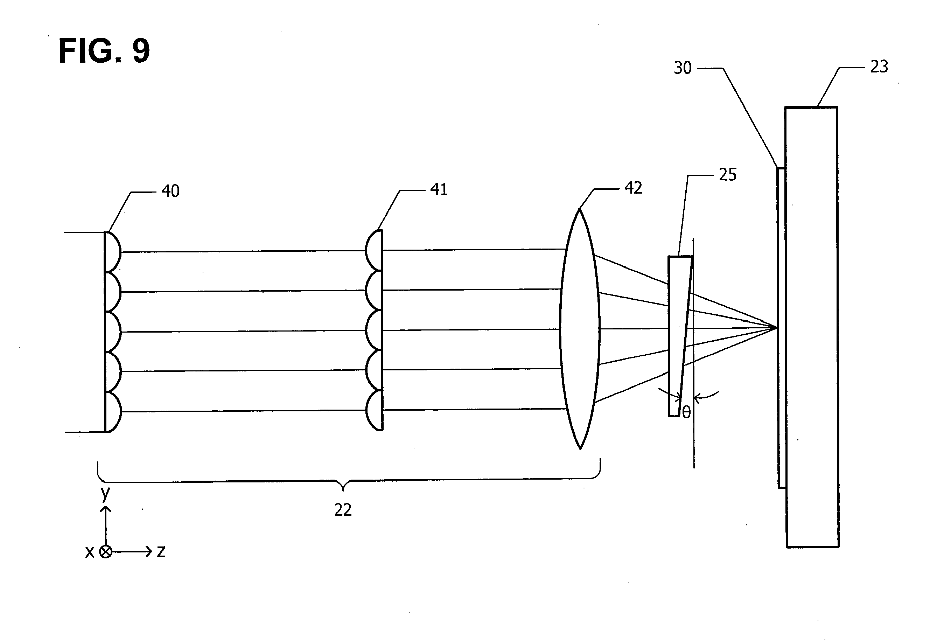

Fig. 9 shows a cross-sectional view of an optical device disposed in a space from the optical homogenizer 22 to the stage 23 of a laser processing apparatus according to Embodiment 3. Hereinafter, differences with Embodiment 1 shown in Fig. 2 will be described, and the descriptions with respect to the same configurations are omitted.

In Embodiment 1, the parallel flat plate is used for the inclination optical device 25. However, in Embodiment 3, a wedge plate is used. One surface of the wedge substrate is parallel to the surface of the workpiece 30, and the other surface is inclined in the short axis direction (y direction) with respect to the surface of the workpiece 30. The inclination angle is represented by θ. In Embodiment 3, one refractive index interface of the inclination optical device 25 is inclined in the short axis direction (y direction) with respect to the surface of the workpiece 30. In addition, both refractive index interfaces of the wedge plate may be inclined with respect to the surface of the workpiece 30.

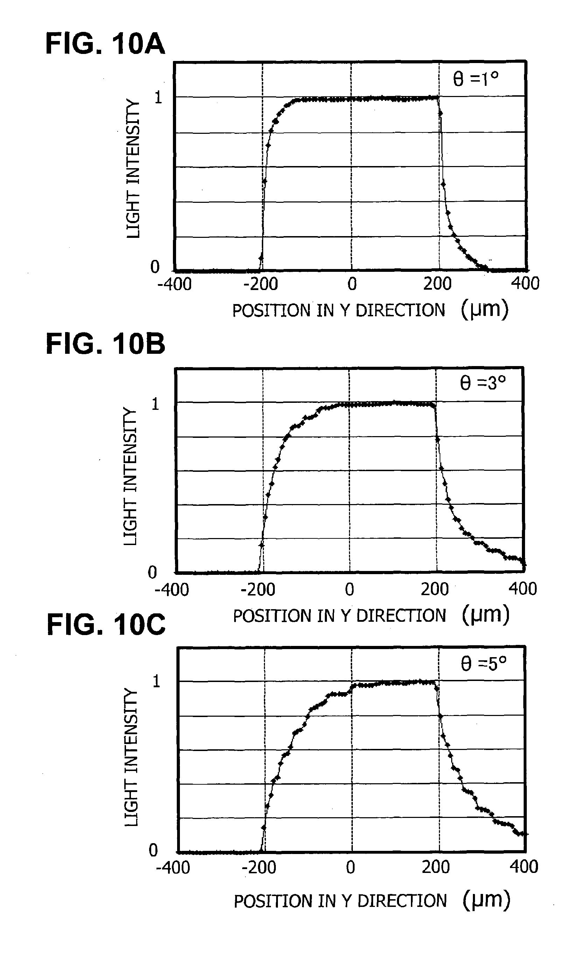

Figs. 10A to 10C show simulation results of the light intensity distribution in the short axis direction on the surface of the workpiece 30 which is held to the stage 23 of the laser processing apparatus according to Embodiment 3. The horizontal axis represents the positions in the y direction when making the focal point of the condenser lens 42 (Fig. 2) origin by a unit "µm". Figs. 10A, 10B, and 10C show the light intensity distribution when the inclination angle θ is 1°, 3°, and 5° respectively. It is understood that the larger the inclination angle θ, the gentler the inclinations of the light intensity distribution at both ends. Thereby, similar to the case of Embodiment 1, the fluctuation of the lightness on the surface of the polycrystallized film can be suppressed. Moreover, also in Embodiment 3, since the laser radiation is performed under the just focus condition, similar to the case of Embodiment 1, the laser processing is not easily subjected to the influence of the undulation of the surface of the workpiece 30.

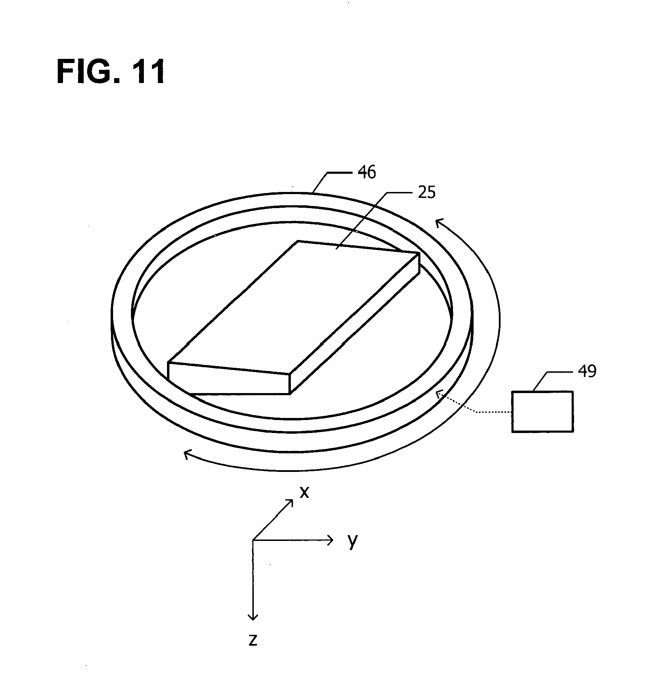

Fig. 11 shows a perspective view of the inclination optical device 25 and the support frame 46 which supports the inclination optical device 25. The support frame 46 has an annular shape, the center axis of which is parallel to the z axis. The rotation-driving mechanism 49 rotates the support frame 46 about the center axis. The support frame 46 is rotated by 180°, and thus, the inclination direction of the refractive index interface of the inclination optical device 25 can be inverted. Thereby, similar to the case of Embodiment 2, even though the movement direction of the workpiece 30 is inverted, the laser processing can be performed under the same condition as that before the inversion.

Although the present invention is described along the above-described Embodiments, the present invention is not limited thereto. For example, it is obvious to a person skilled in the art that various modifications, improvements, combinations, or the like can be performed.

## Claims

1. A laser processing apparatus comprising:
a laser light source;
an optical homogenizer which makes a laser beam emitted from the laser light source be incident upon a region having an elongated shape in a first direction on a workpiece; and
an inclination optical device which is disposed on a pathway of the laser beambetween the optical homogenizer and the workpiece and forms a refractive index interface inclined in a direction perpendicular to the first direction with respect to a surface of the workpiece.

2. The laser processing apparatus according to claim 1,
wherein the inclination optical device includes a parallel flat plate which is inclined with respect to the surface of the workpiece.

3. The laser processing apparatus according to claim 1,
wherein the inclination optical system includes a wedge plate.

4. The laser processing apparatus according to any one of claims 1 to 3,
wherein the optical homogenizer includes:
a first cylindrical lens array which divides the laser beam in a short axis direction in a short axis longitudinal-section perpendicular to the first direction;
a second cylindrical lens array which is disposed on the rear of the first cylindrical lens array and includes a plurality of cylindrical lenses, each of which corresponds to each cylindrical lens which configure the first cylindrical lens array; and
a condenser lens which is disposed on the rear of the second cylindrical lens array and has power in the short axis direction,
wherein each cylindrical lens of the second cylindrical lens array and the condenser lens configure an imaging optical system in which a position where the first cylindrical lens array is allocated corresponds to an object point and the surface of the workpiece corresponds to an image point.

5. The laser processing apparatus according to any one of claims 1 to 4, further comprising:
a rotation-driving mechanism which rotates the inclination optical device so that the inclination direction of the refractive index interface is inverted.

6. A laser processing method in which a workpiece is processed using a laser processing apparatus,
the apparatus including
a laser light source which emits a pulse laser beam; an optical homogenizer which make the laser beam emitted from the laser light source be incident upon a region having an elongated shape in a first direction on the workpiece; and
an inclination optical device which is disposed on an optical path of the laser beam between the optical homogenizer and the workpiece and forms a refractive index interface inclined in a direction perpendicular to the first direction with respect to a surface of the workpiece,
the method comprising:
a first processing step of performing the processing by emitting the pulse laser beam from the laser light source while moving the workpiece in a second direction perpendicular to the first direction;
a step of shifting the workpiece in the first direction after the first processing step;
a second processing step of performing the processing by emitting the pulse laser beam from the laser light source while moving the workpiece in a direction opposite to the movement direction of the workpiece in the first processing step, after shifting the workpiece in the first direction; and
a step of inverting the inclination direction of the refractive index interface between the first processing step and the second processing step.
